# EUROPEAN PATENT APPLICATION

(11) **EP 4 495 296 A1**
(43) Date of publication of application: **22.01.2025**
(21) Application number: 23186603.9
(22) Date of filing: 20.07.2023
(51) Int. Cl.: C30B 7/08, C30B 7/14, B01D 9/00, B01J 19/12, C30B 29/58

(54) **METHOD AND DEVICE FOR LASER-INDUCED NUCLEATION OF A TARGET MOLECULE**

(71) Applicant: Universiteit Antwerpen, 2000 Antwerpen (BE)
(72) Inventor: Dockx, Kristof, 2610 Wilrijk (BE); Vande Velde, Christophe, 2020 Antwerpen (BE); Wenseleers, Wim, 2610 Wilrijk (BE)
(74) Representative: De Clercq & Partners

(57) **Abstract**

Provided herein is a method for laser-induced nucleation of a target molecule, comprising: providing a liquid-gas two-phase slug flow through an irradiation channel, wherein the liquid phase comprises a supersaturated solution of the target molecule and irradiating the liquid-gas two-phase slug flow in the irradiation channel with laser light; wherein there is an angle between the direction of the flow of the liquid-gas two-phase slug flow and the direction of the laser light irradiating said flow.

Provided further is a device (1) for laser-induced nucleation, comprising: an inlet (4) for receiving a liquid-gas two-phase slug flow (6); an irradiation channel (2), an outlet (5), and a laser (3), wherein said laser is configured for irradiating with said irradiation section (20) of the irradiation channel (2) at an angle with the envisaged direction (60) of the flow of the liquid-gas two-phase slug flow (6).

## Description

### Field of the invention

The present invention is in the field of laser-induced nucleation of target molecules, more particular in the field of non-photochemical laser induced nucleation (NPLIN); and that using a liquid-gas two-phase slug flow.

### Background to the invention

The process of nucleation is crucial in various scientific and industrial processes, including crystal growth, precipitation, and phase transitions. Controlling nucleation parameters such as nucleation rate, size, morphology, crystal structure and distribution is vital for obtaining desired material properties, improving process efficiency, and enhancing product quality. Traditional methods for nucleation control often lack precision, requiring complex procedures and leading to inconsistent results.

Laser-induced nucleation of molecules is a process wherein laser light shines in a supersaturated solution, inducing stochastic formation of nuclei of a target molecule. As it is a stochastic process, a large number of different experiments is needed to obtain any statistically relevant data and conclusions on the factors that might influence the formation of the nuclei. Combined with the fact that nucleation is very molecule specific, and hence experiments need to be repeated for every molecule, there is a need for reliable laser-induced nucleation methods and devices which are fast and simple, so to be able to generate a lot of datapoints in a small amount of time. Preferably, the nucleation should be easily reproducible. Therefore, the nucleation method should minimise uncontrollable variation in the method. Preferably also, the nucleation method minimises cross-contamination between different datapoints. Moreover, the nucleation method should not cause any chemical change of the target molecule or any other compound in the system. Finally, the laser-induced nucleation method should be one that can be automated.

As nucleation experiments might sometimes be performed in early-stage medical research, when the target molecule is not yet available in large quantities, there is also a need for nucleation methods and devices which consume small amounts of target molecule.

### Summary of the invention

The methods and devices disclosed herein may meet one or more demands as set out above.

More particularly the invention provides a method for laser-induced nucleation of a molecule using a liquid-gas two-phase slug flow, which is irradiated with laser light at an angle of the flow.

More particularly, provided herein is a method for laser-induced nucleation of a at least first target molecule, comprising:
- providing a liquid-gas two-phase slug flow through an irradiation channel, wherein the liquid phase comprises a supersaturated solution of the at least a first target molecule;
- irradiating the liquid-gas two-phase slug flow in the irradiation channel with laser light, thereby initiating nucleation of the first target molecule;
wherein there is an angle between the direction of the flow of the liquid-gas two-phase slug flow in the irradiation channel and the direction of the laser light irradiating said flow.

In some embodiments, the irradiation channel comprises a flat outer surface section and the laser light enters the irradiation channel through a flat outer surface section of said irradiation channel.

In some embodiments, at least part of the irradiated section of the irradiation channel has a rectangular or square cross-section.

In some embodiments, the at least part of the irradiated section of the irradiation channel is made out of glass or quartz.

In some embodiments, the liquid-gas two-phase slug flow is a segmented slug flow, comprising alternating liquid slugs, fully separated from each other by gas slugs.

In some embodiments, the liquid-gas two-phase slug flow through the irradiation channel is a continuous liquid-gas two-phase slug flow.

In some embodiments, the laser light is pulsed laser light.

In some embodiments, the method comprises the steps of:
- supersaturating an under-saturated solution or saturated solution, preferably by lowering the temperature of said under-saturated solution or said saturated solution, thereby obtaining a supersaturated solution;
- forming a supersaturated liquid-gas two-phase slug flow by initiating a flow said supersaturated solution and mixing it with a gas flow; and/or,
preferably, the method comprises the step of:
- supersaturating an under-saturated liquid-gas two-phase slug flow or saturated liquid-gas two-phase slug flow, preferably by changing the temperature of said under-saturated liquid-gas two-phase slug flow or said saturated liquid-gas two-phase slug flow.

In some embodiments, the method further comprises the step of maturing the irradiated liquid-gas two-phase slug flow allowing growth of the nuclei, preferably in a maturation channel.

In some embodiments, the method further comprises the step of characterizing the formed nuclei, preferably in the liquid slugs.

In some embodiments, the method further comprises the step of harvesting the formed nuclei from the liquid slugs.

In some embodiments, the temperature in the maturation channel is the same temperature as the irradiation channel.

Further provided herein is a device (1) for laser-induced nucleation, comprising:
- an inlet (4) for receiving a liquid-gas two-phase slug flow (6);
- an irradiation channel (2), down-stream of and in fluid connection with said inlet (4);
- optionally, a maturation channel (10), down-stream of and in fluid connection with said irradiation channel (2);
- an outlet (5), down-stream of and in fluid connection with said irradiation channel (2) and optional maturation channel (10);
- a laser (3), for producing laser light (21), configured for irradiating with said laser light an irradiation section (20) of the irradiation channel (2);
wherein the laser (3) is configured to irradiate the irradiation section (20) of the irradiation channel (2) in a direction at an angle (61) with respect to the envisaged direction (60) of the flow of the liquid-gas two-phase slug flow (6) in the irradiation section (20) of the irradiation channel (2), preferably the laser (3) is configured to irradiate the entire irradiation section (20) of the irradiation channel (2) at an angle (61).

In some embodiments, upstream of the inlet (4) for receiving a liquid-gas two-phase slug flow (6), the device comprises a mixer (11), fluidly contented to a single-phase gas inlet (12) and fluidly contented to a single-phase liquid inlet (13).

In some embodiments, the device (1) further comprises an observation unit (30) for observing the liquid-gas two-phase slug flow (6) downstream from the irradiation section (20) of the irradiation channel (2).

### Figure Legends

**Figure 1** shows a schematic layout of a device (1) for laser-induced nucleation according to an embodiment of the invention.
**Figure 2** depicts a cross-section of the irradiation channel (2) of the device (1) shown in Figure 1, at the location of the irradiation section (20) of the irradiation channel (2).
**Figure 3** shows a schematic layout of a more extended embodiment of the device (1) for laser-induced nucleation shown in Figure 1.
**Figure 4** shows the results of an experiment using a method according to an embodiment of the invention in a device according to an embodiment of the invention. The experiment is developed to screen the influence of the laser power on the nucleation fraction of an aqueous potassium chloride solution.
**Figure 5** shows the results of an experiment using a method according to an embodiment of the invention in a device according to an embodiment of the invention. The experiment is developed to screen the influence of the supersaturation (S) on the nucleation fraction.

### Detailed description of invention

Before the present system and method of the invention are described, it is to be understood that this invention is not limited to particular systems and methods or combinations described, since such systems and methods and combinations may, of course, vary. It is also to be understood that the terminology used herein is not intended to be limiting, since the scope of the present invention will be limited only by the appended claims.

As used herein, the singular forms "a", "an", and "the" include both singular and plural referents unless the context clearly dictates otherwise.

The terms "comprising", "comprises" and "comprised of" as used herein are synonymous with "including", "includes" or "containing", "contains", and are inclusive or open-ended and do not exclude additional, non-recited members, elements or method steps. It will be appreciated that the terms "comprising", "comprises" and "comprised of" as used herein comprise the terms "consisting of", "consists" and "consists of".

The recitation of numerical ranges by endpoints includes all numbers and fractions subsumed within the respective ranges, as well as the recited endpoints.

The term "about" or "approximately" as used herein when referring to a measurable value such as a parameter, an amount, a temporal duration, and the like, is meant to encompass variations of +/-10% or less, preferably +/-5% or less, more preferably +/-1% or less, and still more preferably +/-0.1% or less of and from the specified value, insofar such variations are appropriate to perform in the disclosed invention. It is to be understood that the value to which the modifier "about" or "approximately" refers is itself also specifically, and preferably, disclosed.

Whereas the terms "one or more" or "at least one", such as one or more or at least one member(s) of a group of members, is clear *per se,* by means of further exemplification, the term encompasses *inter alia* a reference to any one of said members, or to any two or more of said members, such as, *e.g.,* any ≥3, ≥4, ≥5, ≥6 or ≥7 etc. of said members, and up to all said members.

All references cited in the present specification are hereby incorporated by reference in their entirety. In particular, the teachings of all references herein specifically referred to are incorporated by reference.

Unless otherwise defined, all terms used in disclosing the invention, including technical and scientific terms, have the meaning as commonly understood by one of ordinary skill in the art to which this invention belongs. By means of further guidance, term definitions are included to better appreciate the teaching of the present invention.

In the following passages, different aspects of the invention are defined in more detail. Each aspect so defined may be combined with any other aspect or aspects unless clearly indicated to the contrary. In particular, any feature indicated as being preferred or advantageous may be combined with any other feature or features indicated as being preferred or advantageous.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to a person skilled in the art from this disclosure, in one or more embodiments. Furthermore, while some embodiments described herein include some but not other features included in other embodiments, combinations of features of different embodiments are meant to be within the scope of the invention, and form different embodiments, as would be understood by those in the art. For example, in the appended claims, any of the claimed embodiments can be used in any combination.

In the present description of the invention, reference is made to the accompanying drawings that form a part hereof, and in which are shown by way of illustration only of specific embodiments in which the invention may be practiced. Parenthesized or emboldened reference numerals affixed to respective elements merely exemplify the elements by way of example, with which it is not intended to limit the respective elements. Unless otherwise indicated, all figures and drawings in this document are not to scale and are chosen for the purpose of illustrating different embodiments of the invention. In particular the dimensions of the various components are depicted in illustrative terms only, and no relationship between the dimensions of the various components should be inferred from the drawings, unless so indicated.

It is to be understood that other embodiments may be utilised and structural or logical changes may be made without departing from the scope of the present invention. The following detailed description, therefore, is not to be taken in a limiting sense, and the scope of the present invention is defined by the appended claims.

The inventors have found that the direction of the laser light and the flow direction of the liquid-gas two-phase slug flow in a laser induced nucleation set-up may have an influence on the reproducibility of laser induced nucleation methods and experiments. By not irradiating parallel, but at an angle compared to the flow of a liquid-gas two-phase slug flow, unwanted refraction (focusing and/or defocusing) of the laser light during the laser induced nucleation is reduced, resulting in a more consistent irradiation, and a more reproducible experiment.

As used herein the term "target molecule" refers to the molecule one wishes to obtain nuclei or crystals of. As used herein the term molecule should be interpreted in a broad sense and could cover covalent species and ionic species. The target molecule can be any chemical compound that can crystallise. For example, the target molecule can be a salt, an organic compound, a medicament, a protein, or a biomolecule.

As used herein the term "liquid-gas two-phase slug flow" refers to a flow of a fluids comprising liquid slugs and gas bubbles. Preferably, the liquid slugs are completely separated from each other in the slug flow by gas bubbles. Preferably, when a liquid slug moves through a channel, such as a capillary, the shape of the liquid slugs become elongated (adapting to the inner shape of the capillary) with a curved, circular or hyperbolic front face and back face. The movement of the liquid slug through the capillary may cause vortices within the slug, which may provide continuous mixing of the liquid in the slug, resulting in a homogeneous solution within a liquid slug. Preferably, in between liquid slugs, there is a gas bubble separating the liquid slugs, and in said gas bubble, there are vortices. These vortices in the gas bubble may prevent liquid loss from a liquid slug, and may therefore prevent contamination from one liquid slug to the following liquid slug. The different vortices may stabilize the liquid-gas two-phase slug flow. The advantage of using a liquid-gas two-phase slug flow is that it may allow to generate a lot of different datapoints, as every liquid slug may act as a separate reaction vessel, and therefore can result in a datapoint. It may also allow to provide a flow using a small amount of target molecule as not the complete flow needs to be made up of the stock solution comprising the target molecule, as part of the flow is be provided by incorporating an inert gas. This may result in only needing a few nanolitres or microliters of the stock solution to do a single experiment. Once a stable liquid-gas two-phase slug flow is established, the experiments may be automated and/or continuous.

Compared to a single-phase liquid flow, the liquid-gas two-phase slug flow may have the advantages that cross-talk within the liquid between consecutive experiments may be minimised, variability in residence time may be minimised, and/or that imperfect mixing of the solution may be minimised.

Provided herein is a method for laser-induced nucleation of at least a first target molecule, comprising:
- providing a liquid-gas two-phase slug flow through a channel, hereafter referred to as an "irradiation channel", wherein the liquid phase comprises a supersaturated solution of the at least a first target molecule;
- irradiating the liquid-gas two-phase slug flow in the irradiation channel with laser light, thereby initiating nucleation of the first target molecule;
preferably, wherein there is an angle between the direction of the flow of the liquid-gas two-phase slug flow in the irradiation channel and the direction of the laser light irradiating said flow.

When the laser light would irradiate the liquid-gas two-phase slug flow in the same direction as the flow of said slug flow, i.e. under no angle or parallel to the flow, the laser light enters the liquid slug through either the front face or the back face of the slug. As these front or back faces of the slug are curved, circular or hyperbolic, and as these faces form a gas/liquid interface, the laser light will be heavily focused (and defocused) by these back or front faces. This results in inconsistent irradiation for different liquid slugs, with different local focal points and regions where there is very little laser light for each liquid slug. These varying local focal points may even cause temperature differences between different liquid slug. As the front faces and back faces of the slug may change shape during movement, an uncontrollable variation is introduced in the method, which greatly reduces reproducibility of experiments carried out using the method. The inventors have found that when the laser light is irradiated under an angle compared to the flow of the liquid-gas two-phase slug flow, the variation occurring in the method is reduced, as less laser light enters the liquid slug through the back or front face, and more laser light enters the liquid slug via the capillary/liquid interface of the slug. As this is a solid/liquid interface, the refraction of the laser light becomes more predictable by the interface (compared to a gas/liquid interface), and a more consistent irradiation occurs within different liquid slugs, ultimately resulting in a more reproducible method.

Moreover, when there is no angle between the direction of the laser light and the flow, the laser light going through a first slug may hit the following or previous slug (depending on whether the laser light is aimed in parallel with the flow or counterflow). As this laser light goes through more than one gas/liquid gas interface, the laser light will be heavily disturbed by the refraction of these two interfaces by the time it hits the target, again causing uncontrollable variation in the irradiation of the liquid slugs. The inventors have found that also this cross-contamination by laser light between different slugs decreases when irradiation occurs at an angle, e.g. in crossflow.

The irradiation channel is typically a capillary comprising or consisting of a section which can be irradiated by a laser light. The section of the irradiation channel which is effectively irradiated by the laser light is referred to herein as the "irradiated section" of the irradiation channel. In some embodiments, the method comprises irradiating the liquid-gas two-phase slug flow with laser light at an angle in part of the irradiated section of the irradiation channel. Preferably, the laser light crosses the liquid-gas two-phase slug flow at an angle over the entire length of the irradiated section of the irradiation channel. Meaning that in some embodiments, there is not a single place in the irradiated section of the irradiation channel where the direction of the laser light is parallel to the flow direction of the liquid-gas two-phase slug flow. In practice this implies that the irradiated section of the irradiation channel does not itself comprise bends or turns which would result in the laser hitting the laser light being in parallel to the direction of the envisaged flow within the channel.

In some embodiments, the angle between the direction of the flow of the liquid-gas two-phase slug flow in the irradiation channel and the direction of the laser light irradiating said flow, is at least 30° to at most 150°, preferably at least 45° to at most 135°, preferably at least 60° to at most 120°, preferably at least 75° to at most 105°, preferably at least 80° to at most 100°, preferably at least 85° to at most 95°, preferably 90°.

In some embodiments, the laser irradiation occurs perpendicular to the flow direction of the liquid-gas two-phase slug flow in the complete irradiated section of the irradiation channel. Perpendicular irradiation most significantly reduces the variable (de)focusing effect of the liquid-gas interface on the laser beam. Hence it will result in a more reliable irradiation and therefore a more reliable nucleation.

In some embodiments, the laser light is irradiated in cross-flow with the liquid-gas two-phase slug flow in the irradiation channel.

In some embodiments, the liquid-gas two-phase slug flow is provided through a irradiation channel comprising a flat outer surface section and the laser light enters the capillary through said flat outer surface section of said capillary.. A flat surface minimizes the defocusing of the laser light compared to a round outer surface where the incident angle of the light on the surface is position dependent. Therefore, irradiating the slug flow through a flat outer surface of the irradiated section of the irradiation channel will result in a more reproducible method. Preferably, the laser light enters the irradiation channel through a flat capillary wall, preferably a wall with a flat outer surface and a flat inner surface.

In some embodiments, the laser light enters the irradiation channel through a flat outer surface of the capillary and under an angle of at least 30° to at most 150°, preferably at least 45° to at most 135°, preferably at least 60° to at most 120°, preferably at least 75° to at most 105°, preferably at least 80° to at most 100°, preferably at least 85° to at most 95°, preferably 90°, with said flat outer surface.

As detailed above, in particular embodiments, the irradiation channel will contain an "irradiated section", i.e. a section falling within the range of the laser light and a section which is not irradiated, i.e. which falls outside of the range of the laser light. In some embodiments, at least part of, preferable the entire irradiated section of the irradiation channel has a rectangular or square cross-section. This result in flat outer surfaces, which may lead to less (de)focusing of the laser light upon passing through the irradiation channel.

In some embodiments, at least part of, preferable the entire irradiated section of the irradiation channel is straight. Preventing that the irradiation channel has bends in the irradiated section avoids that these bends would act as lenses which refract the laser light.

In some embodiments, the at least part of the irradiated section of the irradiation channel is made out of glass or quartz. These materials may have a refractive index close to the one of water so that little refraction occurs at the capillary supersaturated (aqueous) solution interface, resulting in less (de)focussing of the laser light.

In some embodiments, at least part of the irradiated section of the irradiation channel and preferably the complete irradiated section of the irradiation channel has an inner diameter of at most 10.0 mm, preferably at most 7.5 mm, preferably at most 5.0 mm, preferably at most 3.0 mm, preferably at most 2.5 mm, preferably at most 2.0 mm, preferably at most 1.5 mm, preferably at most 1.0 mm. In some embodiments, at least part of the irradiated section of the capillary and preferably the complete irradiated section of the capillary has an inner diameter of at least 0.1 mm, preferably at least 0.2 mm, preferably at least 0.5 mm, preferably at least 0.7 mm, preferably at least 0.9 mm. It has been found that such an inner diameter allows to establish a steady slug flow through the capillary without contamination between different liquid slugs. Preferably the complete irradiation channel has the same diameter. This may avoid instability of the liquid-gas two-phase slug flow. The term "slug flow" used herein is sometimes referred to as a Taylor flow or plug flow. In preferred embodiments, the liquid-gas two-phase slug flow is a segmented slug flow, comprising alternating liquid slugs, fully separated from each other by gas slugs. Such a slug flow avoids contamination between the slugs as they are fully separated from each other.

In some embodiments, the interior surface of the irradiation channel is hydrophobic. This may prevent that droplets from one liquid slug stick to the surface of the irradiation channel and get taken up by the next liquid slug, and thereby preventing cross-contamination between liquid slugs. It may also help to establish a liquid-gas two-phase slug wherein the liquid slugs are completely separated from each other.

In some embodiments, the average length of the liquid slugs is at least 0.1 times, preferably at least 0.3 times, preferably at least 0.5 times, preferably at least 0.7 times, preferably at least 1.0 time, the inner diameter of the irradiated section of the irradiation channel. In some embodiments, the average length of the liquid slugs is at least 0.1 times to at most 10.0 times, preferably at least 0.3 times to at most 7.0 times, preferably at least 0.5 times to at most 5.0 times, preferably at least 0.7 times to at most 3.0 times, preferably at least 1.0 time to at most 2.0 times, the inner diameter of the irradiated section of the irradiation channel. Such slugs may be an equilibrium between slug flow stability and number of independent experiments that can be performed per unit of time.

In some embodiments, the average length of the liquid slugs in the irradiated section of the irradiation channel is at least 0.1 mm to at most 10.0 mm, preferably at least 0.2 mm to at most 7.5 mm, preferably at least 0.3 mm to at most 5.0 mm, preferably at least 0.5 mm to at most 3.0 mm, preferably at least 0.7 mm to at most 2.0 mm, preferably at least 0.9 mm to at most 1.5 mm, preferably 1.2 mm.

In some embodiments, two consecutive liquid slugs in the irradiated section of the irradiation channel are spaced apart with a length of at least 1.0 time, preferably at least 1.2 times, preferably at least 1.5 times, preferably at least 1.7 times, preferably at least 2.0 times, preferably at least 3.0 time the average length of the liquid slugs. Such a spacing between the liquid slugs may prevent cross-contamination between slugs. In some embodiments, two consecutive liquid slugs in the irradiated section of the irradiation channel are spaced apart with a length of at least 1.0 time to at most 10.0 times, preferably at least 1.2 times to at most 8.0 times, preferably at least 1.5 times to at most 7.0 times, preferably at least 1.7 times to at most 6.0 times, preferably at least 2.0 times to at most 5.0 times, preferably at least 3.0 times to at most 4.0 times the average length of the liquid slugs. Such a spacing may allow for a good separation between liquid slugs, and may allow for a high number of experiments to be performed per time unit.

In some embodiments, the average length of the gas bubbles in the irradiated section of the irradiation channel is at least 0.1 mm to at most 10.0 mm, preferably at least 0.5 mm to at most 8.0 mm, preferably at least 1.0 mm to at most 6.0 mm, preferably at least 1.5 mm to at most 5.0 mm, preferably at least 2.0 mm to at most 4.0 mm, preferably at least 2.5 mm to at most 3.0 mm.

In some embodiments, the average length of the gas bubbles in the irradiated section of the irradiation channel is at least 0.1 mm, preferably at least 0.5 mm, preferably at least 1.0 mm, preferably at least 1.5 mm, preferably at least 2.0 mm, preferably at least 2.5 mm, preferably at least 3.0 mm, preferably at least 5.0 mm, preferably at least 7.5 mm.

In some embodiments, the liquid/gas volumetric flow ratio of the liquid-gas two-phase slug flow is at least 0.1 to at most 2.0, preferably at least 0.2 to at most 1.8, preferably at least 0.3 to at most 1.7, preferably at least 0.5 to at most 1.5, preferably at least 0.7 to at most 1.3, preferably around 1.0. This may allow to create a stable slug flow and avoid contamination between liquid slugs.

In some embodiments, the liquid-gas two-phase slug flow is provided by mixing a single-phase liquid flow with a single-phase gas flow in a mixer; such as a T -mixer, a Y-mixer, a cross mixer or a coaxial mixer.

In some embodiments, the liquid-gas two-phase slug flow is a continuous liquid-gas two-phase slug flow. This allows for a lot of experiments to be carried out in a short time frame, as every liquid slug can be seen as a separate vessel for experimenting.

In some embodiments, the laser light is pulsed laser light. This may allow to establish a laser power density high enough to initiate nucleation.

In some embodiments, the laser pulse power density is at least 1.0 MW/cm², preferably at least 3.0 MW/cm², preferably at least 5.0 MW/cm², preferably at least 7.0 MW/cm², preferably at least 10.0 MW/cm², preferably at least 15.0 MW/cm².

In some embodiments, the laser is monochromatic laser light.

In some embodiments, the laser-induced nucleation is non-photochemical laser induced nucleation (NPLIN).

In some embodiments, the laser light has a wavelength from at least 350 nm to at most 1100 nm, preferably at least 400 nm to at most 1100 nm, preferably at least 450 nm to at most 1100 nm, preferably at least 500 nm to at most 1100 nm, e.g. 527 nm, 532 nm or 1064 nm.

In some embodiments, the method is a method for co-nucleation of at least a first target molecule together with a second target molecule. This second target molecule may be provided in the same stock solution as the first target molecule, or may be added to the liquid-gas two-phase slug flow in the mixer.

In some embodiments, the method comprises the step of:
- supersaturating an under-saturated solution or saturated solution, preferably by lowering the temperature of said under-saturated solution or said saturated solution, thereby obtaining a supersaturated solution;
- forming a supersaturated liquid-gas two-phase slug flow by initiating a flow said supersaturated solution and mixing it with a gas flow.

In some embodiments, the method comprises the step of:
- supersaturating an under-saturated liquid-gas two-phase slug flow or saturated liquid-gas two-phase slug flow, preferably by lowering the temperature of said under-saturated liquid-gas two-phase slug flow or said saturated liquid-gas two-phase slug flow.

In some embodiments, where solubility of the first target molecule increases with temperature, an undersaturated or saturated liquid-gas two-phase slug flow is provided at a first temperature T1, and wherein before the irradiating step and the maturing step the temperature is lowered to a temperature T2; wherein T1 > T2 to establish supersaturation. This may allow to keep the stock solution undersaturated, to avoid undesirable crystallisation in the stock solution.

In some embodiments, where solubility of the first target molecule decreases with temperature, an undersaturated or saturated liquid-gas two-phase slug flow is provided at a first temperature T1, and wherein before the irradiating step and the maturing step the temperature is increased to a temperature T2; wherein T1 < T2 to establish supersaturation. This may allow to keep the stock solution undersaturated, to avoid undesirable crystallisation in the stock solution.

In some embodiments, the method further comprises the step of observing the irradiated liquid slugs and/or observing the formed nuclei. The observation may be to see if a nucleus is formed in the liquid slug after irradiation or it may be to determine which crystal is formed (e.g. for morphology or crystal type). The observation may further lead to a selection of certain nuclei, for example to be used as seed crystals in a larger crystallisation method.

In some embodiments, the method further comprises the step of maturing the irradiated liquid-gas two-phase slug flow allowing growth of the nuclei, preferably in a maturation channel. The growth of the nuclei may allow easier observation of the nuclei, or allow an easier harvest of the formed nuclei. The maturing step may also allow the use the supersaturation of the solutions in the liquid slug more completely, which may result in a more homogeneous crystal size for the obtained nuclei.

In some embodiments, the method further comprises the step of characterizing the formed nuclei, preferably in the liquid slugs. In some embodiments, the method further comprises the step of harvesting the formed nuclei from the liquid slugs.

In some embodiments, the mixer is connected to the irradiation channel via a flexible tube, preferably a flexible plastic tube. The use of these tubes avoids corners in the connection between the irradiation channel and the mixer, as corner could disturb the stability of the liquid-gas two-phase slug flow, which could lead to contamination between different liquid slugs.

In some embodiments, the maturation channel is a flexible tube, preferably a coiled up flexible tube. This also avoids corners in the tubing after the irradiation, which again avoids contamination between the liquid slugs, whereas the coil may allow to provide a long maturing time in a relatively small volume.

As used herein, the term "maturation channel" may refer to a channel or a tubing wherein maturation of the nuclei can occur after initiation. Preferably, the maturation channel is a capillary.

In some embodiments, the temperature of the maturation channel is the same temperature as of the capillary. Preferably, the capillary and the maturation channel are housed inside the same thermostatic bath.

In some embodiments, the inner diameter of the maturation channel in equal to the inner diameter of the irradiated section of the irradiation channel. Such diameters prevent a sudden change in the slug flow which might disturb the separation between the liquid slugs.

As detailed above, the irradiation channel and/or maturation channel are preferably capillaries. In some embodiments, connections between round tubing or round capillaries and capillaries with a flat inner surface or a rectangular or square cross-section is made via an adaptor piece which gradually changes the cross-section from a round cross-section to the cross-section of the capillary with the flat inner surface or a rectangular or square cross-section. Preferably this adaptor piece is 3D printed. This adapter piece may provide a smooth transition between the different parts, avoiding dead volumes at the transition and therefore may keep the slug flow stable in the irradiated section of the irradiation channel.

In some embodiments, the capillaries in the liquid and gas single phase parts of the setup, upstream from the T-mixer are narrow capillaries (100 µm internal diameter). Their purpose is to generate a pressure gradient between the slug flow region and the flow controllers, which stabilize the volumetric flow rate of gas and liquids. This pressure gradient reduces the feedback of pressure variations in the slug flow regions to the flow controllers and therefore help to keep the slug flow generation stable and reproducible over time.

In particular, the method for laser-induced nucleation of at least a first target molecule, comprises:
- providing a liquid-gas two-phase slug flow through an irradiation channel, wherein the liquid phase comprises a supersaturated solution of the at least a first target molecule;
- irradiating the liquid-gas two-phase slug flow in the irradiation channel with laser light, thereby initiating nucleation of the first target molecule;

wherein there is an angle between the direction of the flow of the liquid-gas two-phase slug flow in the irradiation channel and the direction of the laser light irradiating said flow;
wherein the angle between the direction of the flow of the liquid-gas two-phase slug flow in the irradiation channel and the direction of the laser light irradiation said flow, is at least 30° to at most 150°, preferably at least 80° to at most 100°, preferably 90°; and,
wherein the laser light enters the irradiation channel through a flat outer surface section of said channel.

Provided further is a device configured to carry out the methods of the present invention. More particularly, provided is a device (1) for laser-induced nucleation, comprising:
- an inlet (4) for receiving a liquid-gas two-phase slug flow (6);
- an irradiation channel (2), down-stream of and in fluid connection with said inlet (4);
- optionally, a maturation channel (10), down-stream of and in fluid connection with said irradiation channel (2);
- an outlet (5), down-stream of and in fluid connection with said irradiation channel (2) and optional maturation channel (10);
- a laser (3), for producing laser light (21), configured for irradiating with said laser light an irradiation section (20) of the irradiation channel (2);
preferably wherein, the laser (3) is configured to irradiate the irradiation section (20) of the irradiation channel (2) in a direction at an angle (61) with respect to the envisaged direction (60) of the flow of the liquid-gas two-phase slug flow (6) in the irradiation section (20) of the irradiation channel (2), preferably the laser (3) is configured to irradiate the entire irradiation section (20) of the irradiation channel (2) at an angle (61).

In some embodiments, the laser light is configured to enter the irradiation channel through a surface, preferably a flat outer surface, and under an angle of at least 30° to at most 150°, preferably at least 45° to at most 135°, preferably at least 60° to at most 120°, preferably at least 75° to at most 105°, preferably at least 80° to at most 100°, preferably at least 85° to at most 95°, preferably 90°, with said flat surface.

In some embodiments, at least part, preferably the entire irradiation section of the irradiation channel, configured to be irradiated by the laser light, has a rectangular or square cross-section.

In some embodiments, at least part of the section of the irradiation channel configured to be irradiated by the laser light (i.e. the irradiated section of the irradiation channel) is straight.

In some embodiments, at least part of the section of the irradiation channel configured to be irradiated by the laser light (i.e. the irradiated section of the irradiation channel) is made out of glass or quartz. In some embodiments, upstream of the inlet (4) for receiving a liquid-gas two-phase slug flow (6), the device comprises a mixer (11), fluidly contented to a single-phase gas inlet (12) and fluidly contented to a single-phase liquid inlet (13). The single-phase liquid inlet (13) may be used to provide a stock solution of target molecule.

In some embodiments, a gas pump (15) is provided between the single-phase gas inlet (12) and the mixer (11). In some embodiments, a solution pump (14) is provided between the single-phase liquid inlet (12) and the mixer (11). These pumps may provide pressure, and may regulate the composition and/or the velocity of the liquid-gas two-phase slug flow.

In some embodiments, one or more first barrier channels is/are provided between the gas pump (15) and the mixer (11). In some embodiments, one or more second barrier channel is/are provided between the solution pump (14) and the mixer (11). The purpose of these barrier channels may be to generate a pressure gradient between the mixer and the pumps, which stabilizes the volumetric flow rate of gas and liquids. This pressure gradient may reduce the feedback of pressure variations in the mixer to the pumps and therefore may help to keep the generated liquid-gas two-phase slug flow stable and reproducible over time.

In some embodiments, the device (1) further comprises an observation unit (30) for observing the liquid-gas two-phase slug flow (6) downstream from the irradiation section (20) of the irradiation channel (2). Preferably the observation unit is configured to observe the liquid-gas two-phase slug flow (6) through the irradiation channel (2) or through the maturation channel (10). Preferably the observation unit is positioned at the end section of the maturation channel.

In some embodiments, the observation unit (30) comprises a microscope and/or camera, such as a CCD camera.

In some embodiments, the device (1) comprises a first thermostatic bath (16), for housing the irradiation channel (2) and/or the maturation channel (10).

In some embodiments, the device (1) comprises a second thermostatic bath (18), for housing the mixer and/or the stock solution of the at least first target molecule.

It is to be understood that embodiments of the method are also embodiments of the device, and *vice versa,* whenever applicable.

The methods and devices disclosed herein may be used in crystallisation experiments, for example to establish optimal crystallisation circumstances to crystallise a certain target molecule. Parameters that can be screened using the methods and the devices disclosed herein are the temperature, the wavelength of the laser light, the intensity of the laser light, the pulse rate of the laser light, the pulse duration of the laser light, the concentration of the target molecule, the chemical composition of the solvent, the velocity of the liquid-gas two-phase slug flow, to name a few.

The invention will be more readily understood by reference to the following examples, which are included merely for purpose of illustration of certain aspects and embodiments of the present invention and are not intended to limit the invention.

### Examples

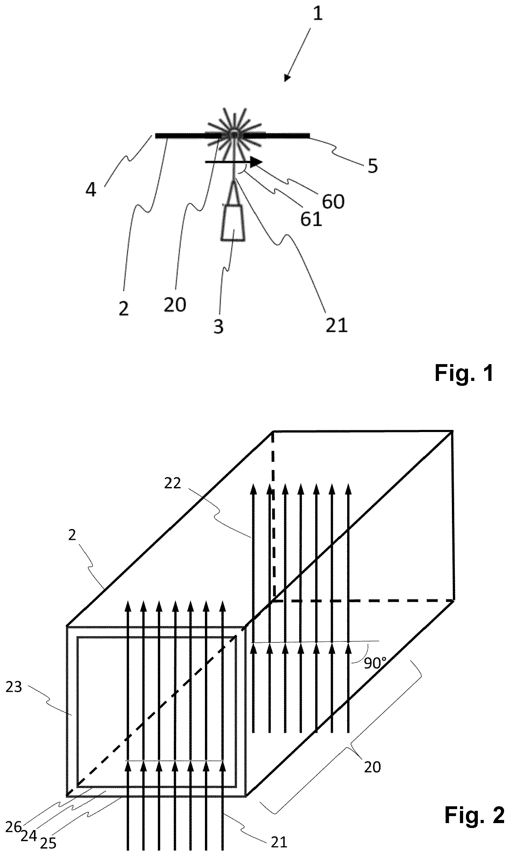

**Figure 1** shows a schematic layout of a device (1) for laser-induced nucleation according to an embodiment of the invention.

The device (1) comprises a capillary (2), through which a liquid-gas two-phase slug flow (not shown) can flow, which can be supplied to the capillary (2) through the inlet (4) and which can leave the capillary through an outlet (5). The liquid-gas two-phase slug flow comprises liquid slugs comprising a solution of at least a first target molecule, and wherein the liquid slugs are separated by gas bubbles. The device further comprises a laser (3) for the generation of laser light (21), and the laser is configured so that the laser light (3) can irradiate a section of the capillary (2), i.e. the irradiation section (20) of the capillary (2); and that at an angle (61) with respect to the envisaged direction (60) of the flow of the liquid-gas two-phase slug flow in the irradiation section (20) of the capillary (2). In this particular example the angle (61) is equal to 90° and that over the entire irradiation section (20) of the capillary (2). When the laser light irradiates a liquid slug within the irradiation section (20) of the capillary (2), nucleation of at least the first target molecule may occur within that liquid slug, forming nuclei comprising at least the first target molecule.

**Figure 2** depicts a cross-section of the irradiation channel (2) of the device (1) shown in Figure 1, at the location of the irradiation section (20) of the irradiation channel (2). The cross-section (23) of the irradiation channel (2) is square, and the walls of the capillary (2), especially the wall (24) through which the laser light (21) is intended to enter the inside of irradiation section (20) of the irradiation channel (2), have a flat outer surface (25) and a flat inner surface (26) parallel to the outer surface (25). The laser light (21) which goes through this wall (24) under an angle (61) of 90°, continues (22) inside the irradiation channel (2) in the same direction and does not get focused or dispersed by the wall (24) of the irradiation channel (2). This may lead to a more uniform and controlled irradiation of the liquid slugs, which in turn may increase the reproducibility of the experiments carried out in the device.

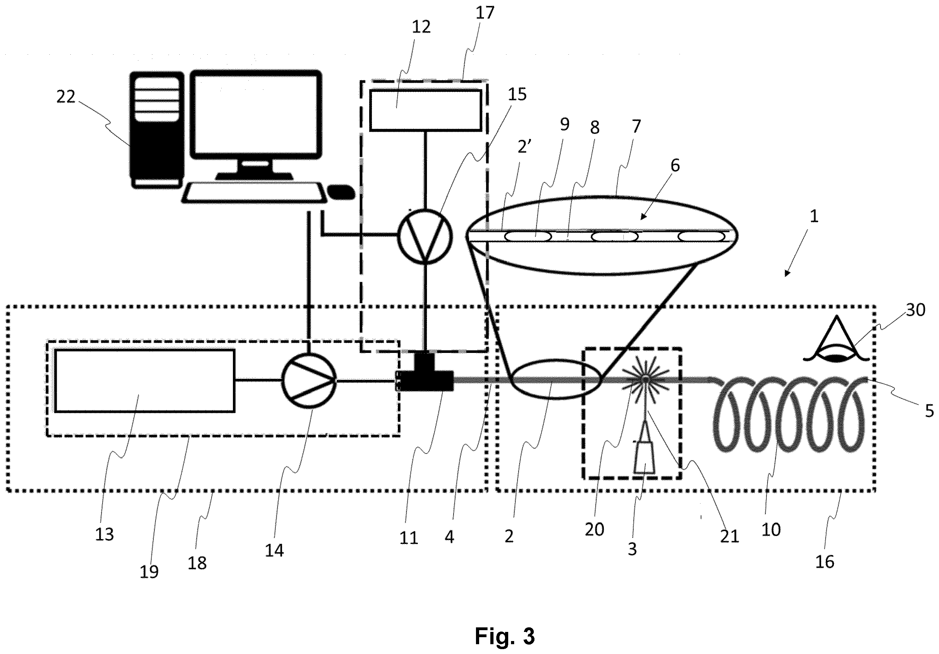

**Figure 3** shows a schematic layout of a more extended embodiment of the device (1) for laser-induced nucleation. The device shown in Figure 3 comprises all the features of the device (1) shown in Figure 1. Furthermore, Figure 3 provides an enlarged view (7) of the irradiation channel (2), which is indicated in the enlarged vied by reference sign (2'). In the enlarged view (7), the liquid-gas two-phase slug flow (6) is depicted as liquid slugs (9), comprising supersaturated solution of a first target molecule, wherein the liquid slugs (9) are fully separated from each outer by gas bubbles (8).

The device of Figure 3 further comprises a maturation channel (10), down-stream of and in fluid connection with said irradiation channel (2). In the maturation channel (10) the formed nuclei (due to the laser irradiation) may grow and mature, so that the liquid slugs (9) and these matured nuclei can be observed by the observation unit (30). The irradiation channel (2) and the maturation channel (10) are placed inside a first thermostatic bath (16), which provides control over the operating temperature T1.

As shown in Figure 3, the device may also comprise a liquid-gas two-phase slug flow generating system. Therefore, a single-phase gas flow (17) is generated out of an (inert) gas supply (12) via a gas pump (15). A single-phase liquid flow (19) is generated out of a solution (13) of the at least first target molecule via a solution pump (14). The single-phase liquid flow (19) and the single-phase gas flow (17) are mixed in a T-mixer (11) to form the liquid-gas two-phase slug flow (6), which is supplied to the inlet (4) of the device. A controller (22) controls the gas pump (15) and the solution pump (14). The single-phase liquid flow (19) and the T-mixer (11) are placed inside a second thermostatic bath (18), which provides control over the operating temperature T2. By applying a T1>T2, an oversaturated solution can be created in the irradiation channel (2), in the case the provided solution in the single-phase liquid flow (19) is not yet saturated.

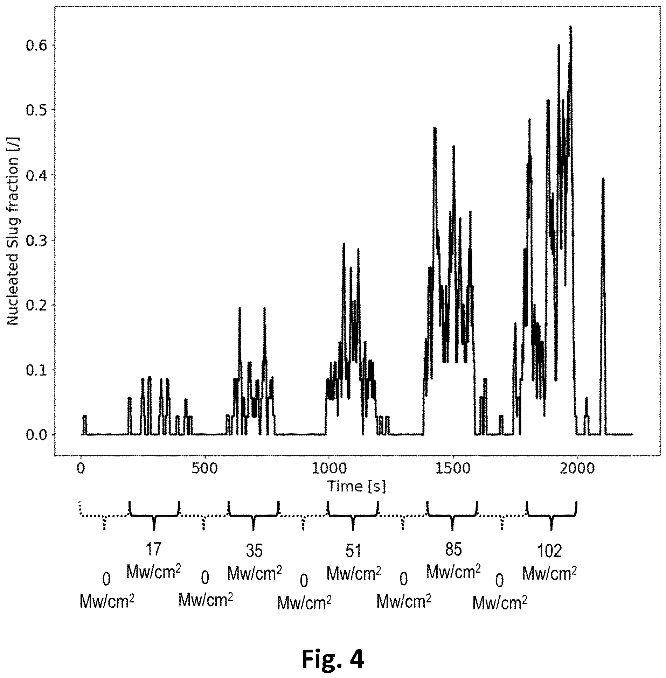

**Figure 4** shows the results of an experiment using the method according to an embodiment of the invention in a device according to an embodiment of the invention (the one depicted in Figure 3). The experiment is developed to screen the influence of the laser power density on the nucleation fraction of an aqueous potassium chloride solution (KCI) of 379.7 g/kg at 23.5°C which corresponds to a supersaturation (S) of 1.08.

A liquid-gas two-phase slug flow is created in the irradiation channel (which is a capillary) in a 1/5 volume ratio (liquid/gas) using nitrogen gas. The average length of the liquid slug was 1,21 mm. The liquid-gas two-phase slug flow moved through the capillary at a velocity of 20 mm/s.

The liquid-gas two-phase slug flow was alternatingly irradiated and not irritated for 200 seconds each time, with a 1000 Hz pulsed laser light with a 200 ns pulse length and a wavelength of 527 nm, and each time with a different laser pulse power density, as provided in table 1 and indicated in Figure 4.

**Table 1: results of nucleation fraction in function of laser power**

| Laser pulse power density [MW/cm²] | Nucleation fraction [/] |
|---|---|
| 17 | 0.021 |
| 35 | 0.056 |
| 51 | 0.111 |
| 85 | 0.226 |
| 102 | 0.313 |

As used herein, the nucleation fraction is defined as the fraction of slugs that contain at least one crystal out of the total number of slugs in the same experimental conditions. Therefore, it is possible that one slug contains more than one crystal, but it will still count as a single point to calculate the nucleation fraction.

This experiment shows that the device can indeed generate NPLIN crystals and NPLIN data. The experiment furthermore shows that the nucleation fraction increases with laser pulse power density.

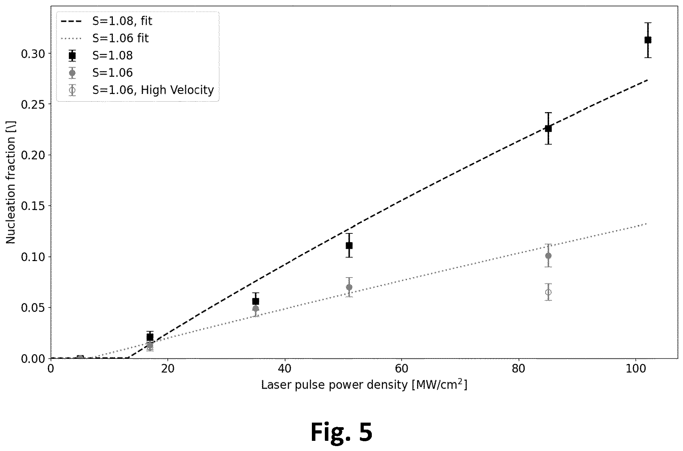

**Figure 5** shows the results of an experiment using the method according to an embodiment of the invention in a device according to an embodiment of the invention (the one depicted in Figure 3). The experiment is developed to screen the influence of the supersaturation (S) on the nucleation fraction. For this experiment different supersaturated KCI solutions were used, i.e. one where S = 1.08 and one where S = 1.06.

3 sets of data points are obtained, by irradiating the following liquid-gas two-phase slug flow:
- S = 1.08 and a velocity is 20 mm/s;
- S = 1.06 and a velocity is 20 mm/s;
- a S = 1.06 and a velocity is 31 mm/s;
with the laser light as applied in the experiment leading to Figure 4, i.e. 200 second on/off with increasing laser pulse power densities (17 MW/cm²; 35 MW/cm²; 51 MW/cm²; 85 MW/cm² and 102 MW/cm²).

The experiment shows that the supersaturation has a positive effect on laser nucleation.

## Claims

1. A method for laser-induced nucleation of a at least first target molecule, comprising:
- providing a liquid-gas two-phase slug flow through an irradiation channel, wherein the liquid phase comprises a supersaturated solution of the at least a first target molecule;
- irradiating the liquid-gas two-phase slug flow in the irradiation channel with laser light, thereby initiating nucleation of the first target molecule;
**characterised in that** there is an angle between the direction of the flow of the liquid-gas two-phase slug flow in the irradiation channel and the direction of the laser light irradiating said flow.

2. The method according to claim 1, wherein the laser light enters the irradiation channel through a flat outer surface section of said irradiation channel.

3. The method according to claim 1 or 2, wherein at least part of the irradiated section of the irradiation channel has a rectangular or square cross-section.

4. The method according to any one of previous claims, wherein the at least part of the irradiated section of the irradiation channel is made out of glass or quartz.

5. The method according to any one of previous claims, wherein the liquid-gas two-phase slug flow provided through the irradiation channel is a continuous liquid-gas two-phase slug flow.

6. The method according to any one of previous claims, wherein the laser light is pulsed laser light.

7. The method according to any one of claims 1 to 6, wherein the method comprises the steps of supersaturating an under-saturated liquid-gas two-phase slug flow or saturated liquid-gas two-phase slug flow, preferably by changing the temperature of said under-saturated liquid-gas two-phase slug flow or said saturated liquid-gas two-phase slug flow.

8. The method according to any one of claims 1 to 6, wherein the method comprises the steps of:
- supersaturating an under-saturated solution or saturated solution, preferably by lowering the temperature of said under-saturated solution or said saturated solution, thereby obtaining a supersaturated solution;
- forming a supersaturated liquid-gas two-phase slug flow by initiating a flow said supersaturated solution and mixing it with a gas flow;

9. The method according to any one of previous claims, wherein the method further comprises the step of maturing the irradiated liquid-gas two-phase slug flow allowing growth of the nuclei, preferably in a maturation channel.

10. The method according to any one of previous claims, wherein the method further comprises the step of characterizing the formed nuclei, preferably in the liquid slugs.

11. The method according to any one of previous claims, wherein the method further comprises the step of harvesting the formed nuclei from the liquid slugs.

12. The method according to any one of previous claims, wherein the temperature in the maturation channel the same temperature as the irradiation channel.

13. A device (1) for laser-induced nucleation, comprising:
- an inlet (4) for receiving a liquid-gas two-phase slug flow (6);
- an irradiation channel (2), down-stream of and in fluid connection with said inlet (4);
- optionally, a maturation channel (10), down-stream of and in fluid connection with said irradiation channel (2);
- an outlet (5), down-stream of and in fluid connection with said irradiation channel (2) and optional maturation channel (10);
- a laser (3), for producing laser light (21), configured for irradiating with said laser light an irradiation section (20) of the irradiation channel (2);
**characterised in that,** the laser (3) is configured to irradiate the irradiation section (20) of the irradiation channel (2) in a direction at an angle (61) with respect to the envisaged direction (60) of the flow of the liquid-gas two-phase slug flow (6) in the irradiation section (20) of the irradiation channel (2), preferably the laser (3) is configured to irradiate the entire irradiation section (20) of the irradiation channel (2) at an angle (61).

14. The device (1) according to claim 13, wherein upstream of the inlet (4) for receiving a liquid-gas two-phase slug flow (6), the device comprises a mixer (11), fluidly contented to a single-phase gas inlet (12) and fluidly contented to a single-phase liquid inlet (13).

15. The device (1) according to claim 13 or 14, wherein the device (1) further comprises an observation unit (30) for observing the liquid-gas two-phase slug flow (6) downstream from the irradiation section (20) of the irradiation channel (2).
